# EUROPEAN PATENT APPLICATION

(11) **EP 1 968 362 A2**
(43) Date of publication of application: **10.09.2008**
(21) Application number: 08151809.4
(22) Date of filing: 22.02.2008
(51) Int. Cl.: H05K 1/14

(54) **Interconnect for an electrical circuit substrate**

(30) Priority: 08.03.2007 US 715688
(71) Applicant: Delphi Technologies, Inc., Troy, Michigan 48007 (US)
(72) Inventor: Burns, Jeffrey H., Kokomo, IN 46902 (US); Delheimer, Charles I., Noblessville, IN 46060 (US)
(74) Representative: Robert, Vincent

(57) **Abstract**

A passive surface mount part (30,32,44) such as a capacitor or a resistor is employed to attach a first substrate (10) to a second substrate (12), or a semiconductor device (18) to a substrate (12), for an electrical circuit assembly. Applicable forms of substrates (10,12) include a printed circuit board such as a motherboard and a daughterboard, and applicable forms of semiconductor devices (18) include an integrated circuit. In an aspect, a low profile attachment is provided forming a planar structure. Space is conserved, signal transmission is provided, and electrical performance is increased. In another aspect, a standoff is defined between the substrates (10,12) setting the substrates apart a desired distance, compensating for any surface irregularities, increasing thermal separation, and increasing interconnect flexibility. As an application, the standoff defined between the substrates (10,12) can be utilized for a structure such as optical glass structure (28) to be situated between the substrates for use with an optical circuit assembly (26).

## Description

### TECHNICAL FIELD

The invention relates generally to an interconnect for an electrical circuit substrate, and more particularly to utilizing a passive surface mount part such as a capacitor or resistor as an interconnect between a motherboard and a daughterboard or between an integrated circuit and a printed circuit board.

### BACKGROUND OF THE INVENTION

Surface-mount technology is used to construct electronic circuits in which the components are mounted directly onto the surface of a printed circuit board (PCB). An electronic device so made is called a surface-mount device (SMD). In industry, SMDs have largely replaced through-hole technology, a previous construction method of fitting components with wire leads into holes in the PCB.

A ball grid array (BGA) is a type of surface-mount packaging used for integrated circuits. Previously, a pin grid array (PGA) was used, which is a package with one face at least partly covered with pins in a grid pattern. These pins are used to conduct electrical signals from the integrated circuit to a printed circuit board (PCB) on which it is placed. PGAs and small-outline integrated circuit (SOIC), or dual-in-line surface mount packages, were being produced with an increasing number of pins, and with decreasing spacing between the pins, causing difficulties for the soldering process. As package pins got closer together, the danger of accidentally bridging adjacent pins with solder grew. In BGA packaging, the pins are replaced by balls of solder applied to the bottom of the package. The device is typically placed on a PCB that carries copper pads in a pattern matching the solder balls. The assembly is then heated, either in a reflow oven or by an infrared heater, causing the solder balls to melt. A disadvantage ofBGAs, however, is that the solder balls cannot flex in the way that longer leads can, so that bending and thermal expansion of the PCB is transmitted directly to the package. This can cause the solder joints to fracture under high thermal or mechanical stress.

A contemporary technique for mounting integrated circuits to suitable substrates involves a flip chip technique. A typical flip chip microelectronic assembly includes an integrated circuit die, also commonly referred to as a chip. The chip is mounted on a substrate, such as a printed circuit board, by solder bump interconnections that physically attach the chip to the substrate and also form electrical connections for conducting electrical signals to and from the chip for processing. An exemplary arrangement of flip chip mounting an integrated circuit to a substrate is disclosed by U.S. patent application Ser. No. 10/317,520, "Optical Information Processing Circuit Assembly," by Tan et al, assigned to the assignee of the present invention, the disclosure of which is hereby incorporated herein by reference.

Daughter cards and multi-chip modules have been attached to a PCB in a variety of ways including connectors, solder balls as described, and even direct soldering. Decoupling capacitors and other passive components then are typically situated occupying valuable space on a PCB. A solution is needed for an improved interconnect that attaches a motherboard to daughterboard, or a PCB to an integrated circuit, which is resistant to fracture because of thermal or mechanical flex, provides added thermal resistance between PCBs, and overcomes other shortcomings of contemporary interconnects. The interconnect should also be able to be used along with additional mounting techniques including the flip chip technique.

### SUMMARY OF THE INVENTION

A method and structure are provided to attach a first substrate to a second substrate for an electrical circuit assembly. The applicable forms of substrates include a printed circuit board such as a motherboard and a daughterboard. The present invention also provides for attachment of a semiconductor device to a substrate, the applicable forms of semiconductor devices including an integrated circuit such as an integrated imaging circuit.

In an embodiment, the present invention provides a low profile attachment of substrates, wherein the substrates are attached forming a planar structure. Space is conserved on a printed circuit board since the present invention interconnect can be utilized as a functional passive component, beyond being a simple interconnect. In one case, signal transmission from the first substrate to the second substrate is routed via the present invention interconnect. Passive components normally occupying space can be utilized as the interconnect and are relocated closer to a component thereby increasing electrical performance.

In an alternative embodiment, a standoff is created between the first substrate and the second substrate to set the two substrates apart a desired distance. The standoff defined between the two substrates can be utilized for a structure such as optical glass to be situated between the two substrates for an optical circuit assembly. Mounting techniques such as a flip chip technique may be used along with the present invention to attach a semiconductor device such as an integrated imaging circuit to one of the substrates. The standoff can serve to compensate for any surface irregularities in either substrate when aligning the substrates.

Additionally, by defining a standoff and also creating space for an intermediate structure, the present invention can maximize the distance between the first substrate and an integrated circuit situated on an opposite side of the second substrate, thereby increasing thermal separation. Interconnect flexibility is also increased between the two substrates, either with a low profile interconnect or with an interconnect forming a standoff between the two substrates.

Features of the invention are achieved in part by employing a passive surface mount part to attach a first substrate to a second substrate, or the second substrate to a semiconductor device. The types of surface mount parts that can be utilized include passive components such as a capacitor, a resistor, a diode or an RF choke. The passive surface mount part is positioned between the first substrate and the second substrate. Alternatively, the passive surface mount part is positioned at a perimeter of at least one of the first substrate and the second substrate, and connects the passive surface mount part, the first substrate and the second substrate. In an embodiment, a solder or an adhesive bond is applied to the passive surface mount part, the first substrate and/or the second substrate, prior to positioning the passive surface mount part. A bond pad for applying the solder may further be situated on either or both of the first substrate and the second substrate.

A standoff can be created between the first substrate and the second substrate, by utilizing the passive surface mount part as an extension therebetween. The solder applied between the passive surface mount part and the substrates may further extend the standoff. Further, by utilizing solder on both ends of the passive surface mount part, interconnect flexibility is increased between the two substrates, either with a low profile interconnect or with an interconnect forming a standoff between the two substrates.

Other features and advantages of this invention will be apparent to a person of skill in the art who studies the invention disclosure. Therefore, the scope of the invention will be better understood by reference to an example of an embodiment, given with respect to the following figures.

### BRIEF DESCRIPTION OF THE DRAWINGS

The foregoing aspects and many of the attendant advantages of this invention will become more readily appreciated by reference to the following detailed description, when taken in conjunction with the accompanying drawings, wherein:
FIG. 1 is a cross sectional view of a prior art electrical circuit assembly wherein a first substrate is attached to a second substrate employing solder bump interconnections therebetween;
FIG. 2 is a cross sectional view of an electrical circuit assembly wherein a first substrate is attached to a second substrate employing solder bump interconnections therebetween, and further including an integrated imaging circuit in cooperation with an optical glass structure situated between the two substrates for an optical circuit assembly, in accordance with an embodiment of the present invention;
FIG. 3 is a cross sectional view of an electrical circuit assembly wherein a first substrate is attached to a second substrate employing a passive surface mount part interconnect such as a capacitor or resistor, in accordance with an embodiment of the present invention;
FIG. 4 is another cross sectional view of an electrical circuit assembly wherein a first substrate is attached to a second substrate employing a passive surface mount part interconnect such as a capacitor or resistor, and further including an integrated imaging circuit in cooperation with an optical glass structure situated between the two substrates for an optical circuit assembly, in accordance with an embodiment of the present invention;
FIG. 5A illustrates steps in attaching substrates or a semiconductor device and a substrate, for high temperature tolerant components, in accordance with an embodiment of the present invention; and
FIG. 5B illustrates steps in attaching substrates or a semiconductor device and a substrate, for temperature sensitive components, in accordance with an embodiment of the present invention.

### DESCRIPTION OF THE PREFERRED EMBODIMENTS

Exemplary embodiments are described with reference to specific configurations. Those of ordinary skill in the art will appreciate that various changes and modifications can be made while remaining within the scope of the appended claims. Additionally, well-known elements, devices, components, methods, process steps and the like may not be set forth in detail in order to avoid obscuring the invention. Further, unless indicated to the contrary, any numerical values set forth in the following specification and claims are approximations that may vary depending upon the desired characteristics sought to be obtained by the present invention.

An apparatus and method is described herein for attaching a first substrate to a second substrate for an electrical circuit assembly. The applicable forms of substrates include a printed circuit board such as a motherboard and a daughterboard. The present invention can further attach a semiconductor device to a substrate, the applicable forms of semiconductor devices including an integrated circuit such as an integrated imaging circuit. The present invention employs a passive surface mount part to attach a first substrate to a second substrate, or the second substrate to a semiconductor device. The types of passive surface mount parts that can be utilized include passive components such as a capacitor, a resistor, a diode or an RF choke.

In an embodiment, a low profile attachment of substrates is provided, wherein the substrates are attached forming a planar structure. Space is conserved and electrical performance is increased on a printed circuit board since the present invention interconnect can be utilized as a functional passive component, beyond performing as an interconnect.

In an alternative embodiment, a standoff is created between the first substrate and the second substrate to set the two substrates apart a desired distance. The standoff can serve to compensate for any surface irregularities in either substrate when aligning the substrates. Additionally, by defining a standoff and also creating space for an intermediate structure, the present invention can maximize the distance between the first substrate and an integrated circuit situated on an opposite side of the second substrate, thereby increasing thermal separation. Interconnect flexibility is also increased between the two substrates, either with a low profile interconnect or with an interconnect forming a standoff between the two substrates.

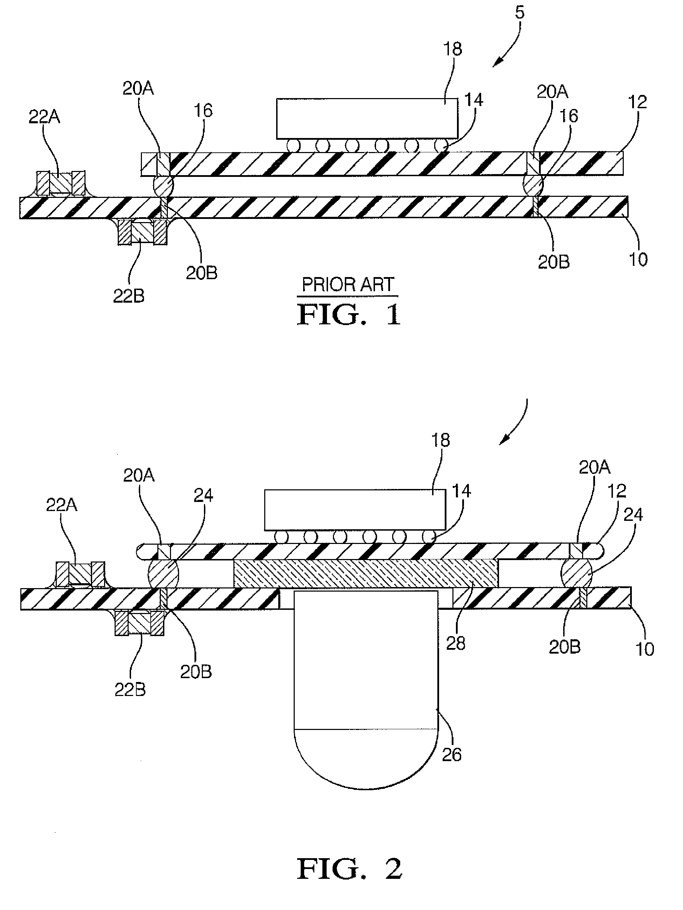

Referring to the drawings wherein identical reference numerals denote the same elements throughout the various views, **FIG. 1** illustrates a cross sectional view of a prior art electrical circuit assembly 5 wherein a first substrate 10 is attached to a second substrate 12 employing solder bump interconnections 16 therebetween. Solder bump interconnections 14 are further employed between integrated circuit 18 and second substrate 12.

This contemporary design results in a number of disadvantages in comparison to the present invention. As shown, passive components 22A and 22B are situated adjacent to the interconnect between first substrate 10 and second substrate 12, thereby occupying valuable space. Also, the distant positioning of the passive components 22A and 22B (i.e., decoupling capacitor) decreases electrical performance of the circuit. Further, by defining a small spacing between the two substrates, low thermal isolation exists between the two substrates. Any bending or thermal expansion of either substrate is transmitted directly to the solder bump interconnections 16. This can cause the solder joints to fracture under high thermal or mechanical stress. Flex fatigue of the solder is a concern since two solder joints exist for each solder bump interconnection 16. If a solder fatigue separation occurs, any signal transmission between the first substrate 10 and the second substrate 12, routed via the solder bumps interconnections 14 and 16, would be disconnected.

An electrical circuit assembly 9 is illustrated in **FIG. 2** wherein first substrate 10 is attached to second substrate 12 employing solder interconnections 24 therebetween. As shown, solder interconnections 24 may be shaped as a column and are larger or taller to define a standoff, as compared to solder bump interconnections 16 as shown in FIG. 1. The standoff may be used for optical glass 28 situated between the two substrates as used in cooperation with an integrated imaging circuit 18 for an optical circuit assembly.

Passive components 22A and 22B are situated adjacent to the interconnect between first substrate 10 and second substrate 12, thereby occupying valuable space. Electrical performance of the circuit is also decreased by the distant positioning of the passive components 22A and 22B. Flex fatigue of the solder interconnections 24 is a concern under high thermal or mechanical stress, since a solder fatigue fracture or separation causes loss of signal transmission between the first substrate 10 and the second substrate 12.

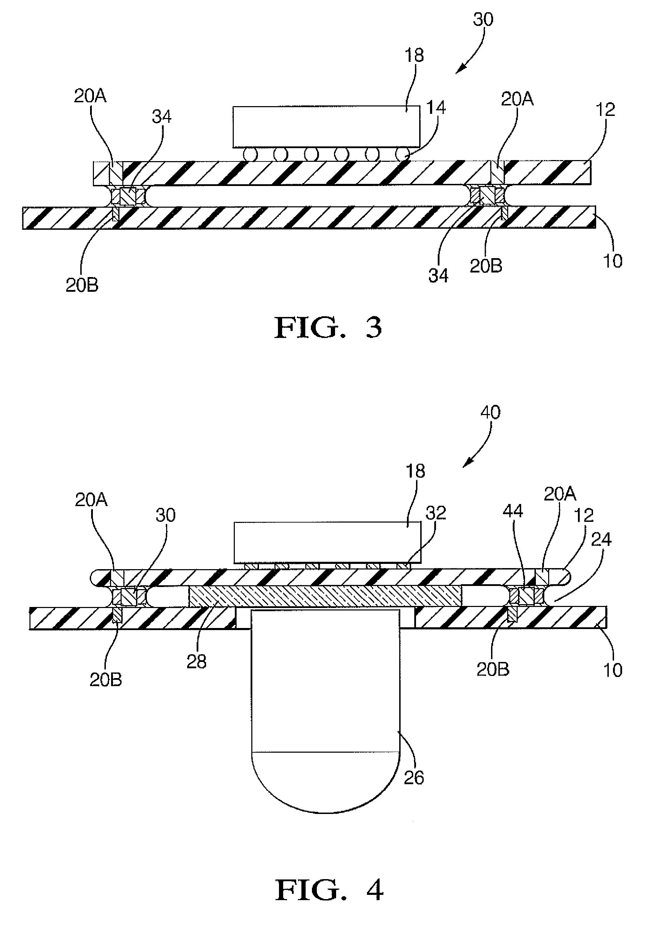

Referring to **FIG. 3****,** a cross sectional view is shown of an electrical circuit assembly 30 wherein a first substrate 10 is attached to a second substrate 12 employing a passive surface mount part interconnect 34 such as a capacitor or resistor. The applicable forms of substrates include ceramic, flex, low temperature co-fired ceramic (LTCC), high temperature co-fired ceramic (HTCC), flame resistant 4 (FR-4), and the like. A substrate may also include a printed circuit board such as a motherboard and a daughterboard. A motherboard is also known as, and is defined herein as, a mainboard, logic board or systemboard, and is the central or primary circuit board making up a complex electronic system, such as a computer. The motherboard typically contains the main expansion bus, and usually also the CPU. A daughterboard or daughtercard as defined herein is a circuit board intended as an extension or daughter of a motherboard, or occasionally another card. The types of passive surface mount components that can be utilized include passive components such as a capacitor, a resistor, a diode or an RF choke. In another embodiment, a spacer is utilized as the interconnect. The spacer may be formed of a metal or other material having a thin metal coating. Additionally, it is to be appreciated that the present invention is useful in electrical circuit assemblies where the second substrate 12 possesses either a higher or a lower functionality/complexity as compared with the first substrate 10.

A low profile attachment of substrates is provided, wherein first substrate 10 and second substrate 12 are attached forming a planar structure. Space is conserved on a printed circuit board since the present invention interconnect can be utilized as a functional passive component, beyond being a simple interconnect. That is, passive components normally occupying space (i.e., passive components 22A and 22B shown in FIG. 1) can be utilized as an interconnect, and are relocated closer to a component thereby increasing electrical performance. In one case, a signal transmission pathway 20A and 20B from the first substrate 10 to the second substrate 12 is routed by way of passive surface mount part 34. The signal transmission pathway may be formed either on the outside of substrates 10 and 12 or through a via defined through substrates 10 and 12, for connecting with passive surface mount part 34.

The passive surface mount part 34 may be positioned between the first substrate 10 and the second substrate 12. Alternatively, the passive surface mount part 34 is positioned at a perimeter of at least one of the first substrate 10 and the second substrate 12, and connects the passive surface mount part 34, the first substrate 10 and the second substrate 12. In an embodiment, a solder or an adhesive bond is applied to the passive surface mount part 34, the first substrate 10 and/or the second substrate 12, prior to positioning the passive surface mount part 34. A bond pad for applying the solder thereto may further be situated in a corresponding arrangement on either or both of the first substrate 10 and the second substrate 12.

In an alternative embodiment, a standoff is created between the first substrate 10 and the second substrate 12, by utilizing passive surface mount part 34 as an extension therebetween. The solder applied between the passive surface mount part 34 and the substrates 10 and 12 may further extend the standoff. Further, by utilizing solder on both ends of the passive surface mount part 34, interconnect flexibility is increased between the two substrates 10 and 12, either with a low profile interconnect or with an interconnect forming a standoff between the two substrates 10 and 12.

**FIG. 4** shows another cross sectional view of an electrical circuit assembly 40 wherein a first substrate 10 is attached to a second substrate 12 employing a passive surface mount part 44 as an interconnect. As further illustrated, the present invention also provides for attachment of a semiconductor device to a substrate 12, by employing passive surface mount part 32 as an interconnect. The applicable forms of semiconductor devices include an integrated circuit such as an integrated imaging circuit 18. Integrated imaging circuit 18 functions in cooperation with lens assembly 26 and optical glass structure 28, for use with an optical circuit assembly. The optical glass structure 28 is situated between the two substrates 10 and 12, and is positioned to receive light passing from lens assembly 26, the lens assembly 26 connected an optical circuit assembly, which is connected to the electrical circuit assembly.

A standoff is created, utilizing the passive surface mount part 32, between the first substrate 10 and the second substrate 12 to set the two substrates 10 and 12 apart a desired distance. The standoff defined between the two substrates 10 and 12 may be utilized to accommodate optical glass structure 28. It is to be appreciated that mounting techniques such as a flip chip technique may be used along with the present invention to attach integrated imaging circuit 18 to substrate 12. The standoff can also serve to compensate for any surface irregularities in either substrate 10 or 12 when aligning the substrates. Additionally, by defining a standoff and also creating space for an intermediate structure (i.e., optical glass structure 28), the present invention can maximize the distance between first substrate 10 and an integrated circuit (i.e., integrated imaging circuit 18) situated on an opposite side of the second substrate 12, thereby increasing thermal separation between the integrated circuit and the first substrate 10. Interconnect flexibility is also increased between the two substrates 10 and 12, either with a low profile interconnect or with an interconnect forming an enlarged standoff between the two substrates.

In an embodiment, a method for attaching the first substrate 10 to the second substrate 12 employing a passive surface mount part as an interconnect is now described. The methods vary depending on whether the substrates or components attached thereto are temperature tolerant or temperature sensitive. Although a conventional solder reflow is described, the passive surface mount parts can alternatively be attached to the substrates using thermo-compression or adhesive bonding techniques.

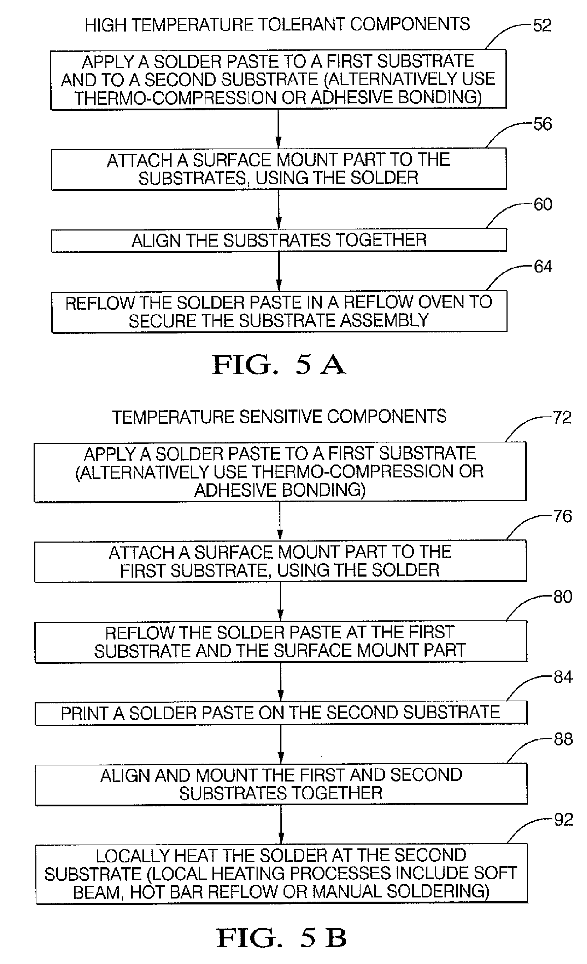

**FIG. 5A** illustrates example steps in attaching substrates or a semiconductor device and a substrate, for high temperature tolerant components. In step 52, a solder paste is applied to both substrates. Alternatively, thermo-compression or adhesive bonding is utilized. In step 56, the passive surface mount part is then attached to the substrates. In step 60, the substrates are then aligned together. In step 64, the solder paste is reflowed in a reflow oven to secure the substrate assembly. The reflow oven is a high-precision oven wherein the substrates move through on a conveyor belt, and are therefore subjected to a controlled time-temperature profile.

**FIG. 5B** illustrates example steps in attaching substrates or a semiconductor device and a substrate, for temperature sensitive components. In step 72, a solder paste is applied to a first substrate. Alternatively, thermo-compression or adhesive bonding is utilized. In step 76, the passive surface mount part is then attached to the first substrate. In step 80, the solder paste is then reflowed at the first substrate and the passive surface mount part. In step 84, a solder paste is next printed on the second substrate, optionally utilizing a bond pad. In step 88, the first and second substrates are then aligned and mounted together. In step 92, the solder at the second substrate is locally heated. Local heating may be accomplished using processes such as Soft Beam, Hot Bar Reflow, or manual soldering.

Other features and advantages of this invention will be apparent to a person of skill in the art who studies this disclosure. Thus, exemplary embodiments, modifications and variations may be made to the disclosed embodiments while remaining within the spirit and scope of the invention as defined by the appended claims.

## Claims

1. A method of attaching a first substrate (10) to a second substrate (12) for an electrical circuit assembly (30) comprising:
positioning a passive surface mount part (34) to attach the first substrate (10) to the second substrate (12), wherein, one of, the passive surface mount part (34) is positioned between the first substrate (10) and the second substrate (12), and the passive surface mount part (34) is positioned at a perimeter of at least one of the first substrate (10) and the second substrate (12); and
connecting the passive surface mount part (34), the first substrate (10) and the second substrate (12).

2. The method as in claim 1, wherein the passive surface mount part (34) comprises one of a capacitor, a resistor, an inductor, a spacer, a diode and an RF choke.

3. The method as in claim 1, further comprising applying one of a solder and an adhesive bond to at least one of the passive surface mount part (34), the first substrate (10) and the second substrate (12), prior to positioning the passive surface mount part (34).

4. The method as in claim 3, wherein the applying the solder comprises applying the solder to a bond pad situated on at least one of the first substrate (10) and the second substrate (12).

5. The method as in claim 1, further comprising establishing a signal transmission connection (20A, 20B) to and from the first substrate (10) and the second substrate (12) via the passive surface mount part (34).

6. The method as in claim 1, further comprising defining a standoff between the first substrate (10) and the second substrate (12), utilizing the passive surface mount part (34) as an extension therebetween.

7. The method as in claim 6, further comprising situating an optical glass structure (28) in the standoff, the optical glass structure (28) positioned to receive light passing from a lens assembly (26) connected to the electrical circuit assembly (40), for use with an optical circuit assembly.

8. The method as in claim 1, wherein the first substrate (10) and the second substrate (12) comprise one of ceramic, flex, low temperature co-fired ceramic (LTCC), high temperature co-fired ceramic (HTCC), flame resistant 4 (FR-4), and a printed circuit board, the printed circuit board comprising one of a motherboard and a daughterboard.

9. The method as in claim 1, further comprising:
attaching a semiconductor device (18) to the second substrate (12), wherein, one of, a second passive surface mount part (32) is positioned between the semiconductor device (18) and the second substrate (12), and the second passive surface mount part (32) is positioned at a perimeter of at least one of the semiconductor device (18) and the second substrate (12); and
connecting the second passive surface mount part (32), the second substrate (12) and the semiconductor device (18).

10. The method as in claim 9, wherein the semiconductor device (18) is an integrated circuit comprising an integrated imaging circuit.

11. An electrical circuit assembly (30) having a first substrate (10) and a second substrate (12) comprising:
a passive surface mount part (34) connecting the first substrate (10) to the second substrate (12), wherein, one of, the passive surface mount part (34) is positioned between the first substrate (10) and the second substrate (12), and the passive surface mount part (34) is positioned at a perimeter of at least one of the first substrate (10) and the second substrate (12).

12. The electrical circuit assembly (30) as in claim 11, wherein the passive surface mount part (34) is a passive component including one of a capacitor, a resistor, an inductor, a spacer, a diode and an RF choke.

13. The electrical circuit assembly (30) as in claim 11, further comprising one of a solder and an adhesive bond situated between at least one of the passive surface mount part (34) and the first substrate (10), and the passive surface mount part (34) and the second substrate (12).

14. The electrical circuit assembly (30) as in claim 11, further comprising a signal transmission connection (20A, 20B) to and from the first substrate (10) and the second substrate (12) via the passive surface mount part (34).

15. The electrical circuit assembly (30) as in claim 11, further comprising a standoff defined by the passive surface mount part (34) extending between the first substrate (10) and the second substrate (12).

16. The electrical circuit assembly (30) as in claim 15, further comprising an optical glass structure (28) situated in the standoff, the optical glass structure (28) positioned to receive light passing from a lens assembly (26) connected to the electrical circuit assembly (40), for use with an optical circuit assembly.

17. The electrical circuit assembly (30) as in claim 11, wherein the first substrate (10) and the second substrate (12) comprise one of ceramic, flex, low temperature co-fired ceramic (LTCC), high temperature co-fired ceramic (HTCC), flame resistant 4 (FR-4), and a printed circuit board, the printed circuit board comprising one of a motherboard and a daughterboard.

18. The electrical circuit assembly (30) as in claim 11, wherein a semiconductor device (18) is connected to the second substrate (12) via a second passive surface mount part (32), wherein, one of, the second passive surface mount part (32) is positioned between the semiconductor device (18) and the second substrate (12), and the second passive surface mount part (32) is positioned at a perimeter of at least one of the semiconductor device (18) and the second substrate (12).

19. The electrical circuit assembly (40) as in claim 18, wherein the semiconductor device (18) is an integrated circuit comprising an integrated imaging circuit.

20. A method of attaching a semiconductor device (18) to a substrate (12) for an electrical circuit assembly (40), comprising:
positioning a passive surface mount part (32) to attach the semiconductor device (18) to the substrate (12), wherein, one of, the passive surface mount part (32) is positioned between the semiconductor device (18) and the substrate (12), and the passive surface mount part (32) is positioned at a perimeter of at least one of the semiconductor device (18) and the substrate (12); and
connecting the passive surface mount part (32), the semiconductor device (18) and the substrate (12).

21. The method as in claim 20, wherein the passive surface mount part (32) is a passive component including one of a capacitor, a resistor, a diode and an RF choke, wherein the semiconductor device (18) is an integrated circuit comprising an integrated imaging circuit, and wherein the substrate (12) comprises one of ceramic, flex, low temperature co-fired ceramic (LTCC), high temperature co-fired ceramic (HTCC), flame resistant 4 (FR-4), and a printed circuit board, the printed circuit board comprising one of a motherboard and a daughterboard.

22. The method as in claim 20, further comprising defining a standoff between the semiconductor device (18) and the substrate (12), utilizing the passive surface mount part (32) as an extension therebetween.
